# EUROPEAN PATENT SPECIFICATION

(11) **EP 0 160 773 B1**
(45) Date of publication and mention of the grant of the patent: **01.09.1993**
(21) Application number: 84830331.9
(22) Date of filing: 06.12.1984
(51) Int. Cl.: H01F 10/24, H03H 2/00

(54) **Method for the suppression of magnetostatic waves within magnetic garnet films for microwave circuit application**
Methode zur Unterdrückung von magnetostatischen Wellen in magnetischen Granatfilmen für Mikrowellenschaltungsanwendungen
Méthode pour la suppression des ondes magnétostatiques dans les films magnétiques de grenat, par applications dans des circuits de micro-ondes

(30) Priority: 21.02.1984 IT 4773384
(43) Date of publication of application: 13.11.1985
(73) Proprietor: SELENIA INDUSTRIE ELETTRONICHE ASSOCIATE S.p.A., I-00131 Roma (IT); I.E.S.S. C.N.R., I-00131 Roma (IT)
(72) Inventor: De Gasperis, P., I-00131 Roma (IT); Roveda, R., Roma (IT); Di Gregorio, Carlo, Dr., I-00046 Grottaferrata (IT); Miccoli, G., I-00191 Roma (IT)
(74) Representative: Gustorf, Gerhard, Dipl.-Ing.

(56) References cited:
- EP-A- 0 021 878
- US-A- 3 845 477
- PATENT ABSTRACTS OF JAPAN, vol. 5, no. 15 (E-43)[687], 29th January 1981; & JP-A-55 143 009 (MATSUSHITA DENKI SANGYO K.K.) 08-11-1980
- IEEE TRANSACTIONS ON MAGNETICS, vol. MAG-18, no. 6, November 1982, pages 1624-1626, IEEE; C. BORGHESE et al.: "On the nature of the microwave spectra and relaxation in conductive Fe 4+ -doped garnet films"
- AIP CONFERENCE PROCEEDINGS, no. 34, 1976, pages 265-267, New York, US; J. GUIDEVAUX et al.: "Improved microwave devices using narrow linewidth garnets"

## Description

The invention concernes a method for the controlled suppression of magnetic waves in garnet films for microwave applications.

In Patent Abstracts of Japan, vol. 5, no. 15 (E-43) < 687 >, 29th January 1981, & JP-A-55 143 009, a material for surface static magnetic wave is proposed to improve the excitation and propagation characteristics of said wave. This object is achieved by coating a YIG thin film containing special element on a gadolinium gallium garnet substrate when forming a surface static magnetic wave device.

A similar device is known by EP-A-21 878 which is part of the prior art as specified in the preamble of claim 1.

The present invention applies to a planar technology for the partial or total suppression of magnetostatic modes. It figures among those materials technologies through which microwave signal processors may be constructed, with particular reference to radar systems, electronic warfare, telecommunication satellites, avionics and related instrumentation.

Such systems pose continous requests for higher operational frequencies and wider bandwidths.

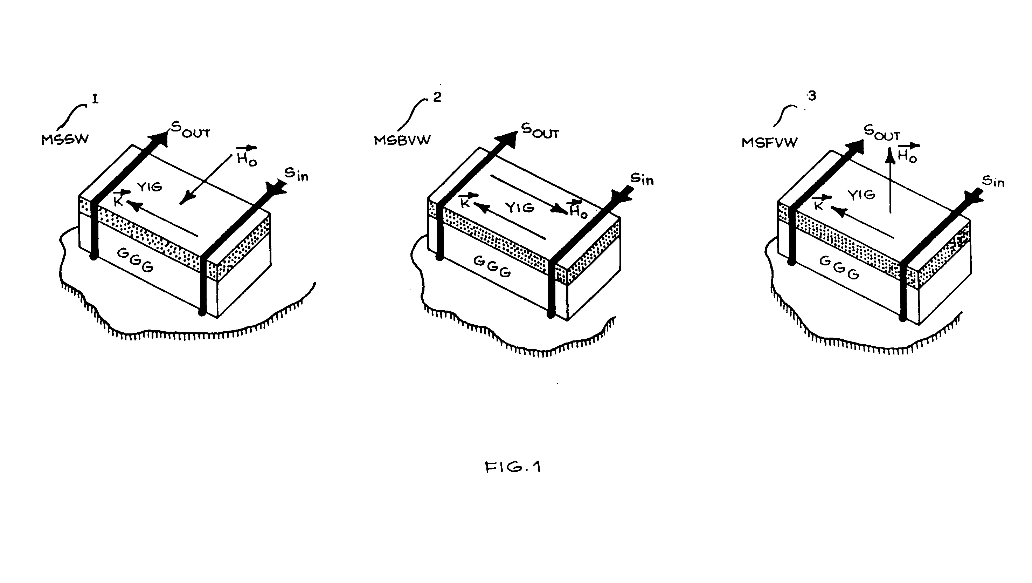

This fact acts as an incentive in the search for new techniques and technologies for signal processing. A new analogue technique makes its appearance in this scenario, useable in the microwave field, based upon magnetostatic wave propagation (MSW) in Yttrium-Iron garnet class ferrimagnetic films (YIG, Y₃,Fe₅O₁₂ and cationic replaced derivations such as La,Ga: YIG) having low losses, realized by means of liquid phase epitaxy (LPE).MSW are slow electromagnetic waves which propagate at microwave frequencies in magnetically biased ferrites. Their salient features are:
- Power level: : from µW to mW order of magnitude
- Frequency range: : 0.5 to 20 GHz
- Velocity range: : 3 to 300 mm/µsec
High coupling efficiency
- Progation losses: : down to 0.02 dB/nsec
- Bandwidth: : up to 1 GHz
- Dynamic interval: : + 50 dB
- Delay times: : 1 to 1000 nsec
- Magnetic field bias: : 0.1 to 10 KOe (796 $\frac{\text{KA}}{\text{m}}$ )
MSW can be tuned to all microwave frequencies by varying the magnetic bias field (Hₒ). Depending upon the orientation of Hₒ, with respect to the sample plane, it is possible to generate surface modes (MSSW) and/or forward (MSFW) and backward (MSBW) volume modes, as outlined in fig.1.

Devices using MSSW have cutoff frequencies given by ${\text{γ (H}}_{\text{o}} {\text{+ 2π M}}_{\text{s}} \text{)}$ ,(low),and
γ √H̅ₒ̅(̅H̅ₒ̅ +̅ 4̅π̅ M̅ₛ̅)̅, (high), respectively, where γ is the gyromagnetic constant (= 2.81 MHz/Oe for YIG) and 4 π Mₛ is the saturation magnetization (= 1.750 G) (0,175 T) for YIG at ambient temperature).

Devices operating in volume modes have respectively the following cutoff frequencies
γ √H̅ₒ̅ (̅H̅ₒ̅ +̅ 4̅ π̅ M̅ₛ̅)̅ and γHₒ.

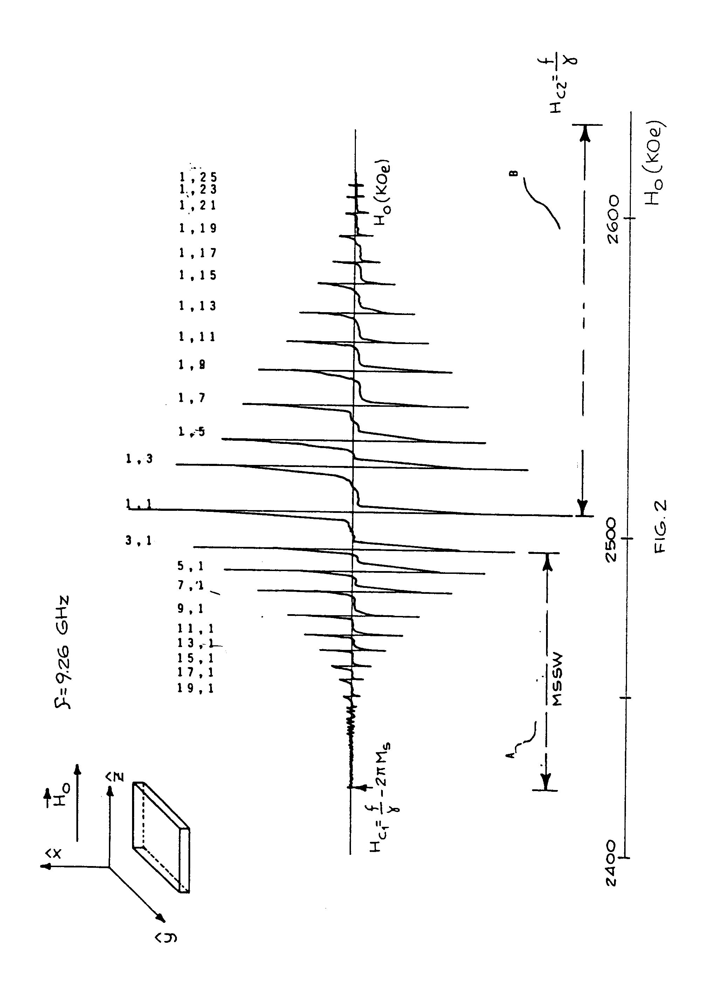

As an example fig.2 shows a typical ferrimagnetic resonance (FMR) spectrum on a square chip (2.3x2.3 mm²) made of YIG, at the fixed frequency of 9.26 GHz, where field Hₒ is parallel to the film plane: in such configuration both MSSW and MSBVW modes are excited simultaneously. For each mode the respective wave numbers (n_{y}, n_{z}) are indicated, related to wave vectors parallel to the film plane by the following:

${\text{K}}_{\text{y}} {\text{= n}}_{\text{y}} {\text{/l}}_{\text{y}}$
${\text{K}}_{\text{z}} {\text{= n}}_{\text{z}} {\text{/l}}_{\text{z}}$

where l_{y}, l_{z} are the chip's lateral dimensions.

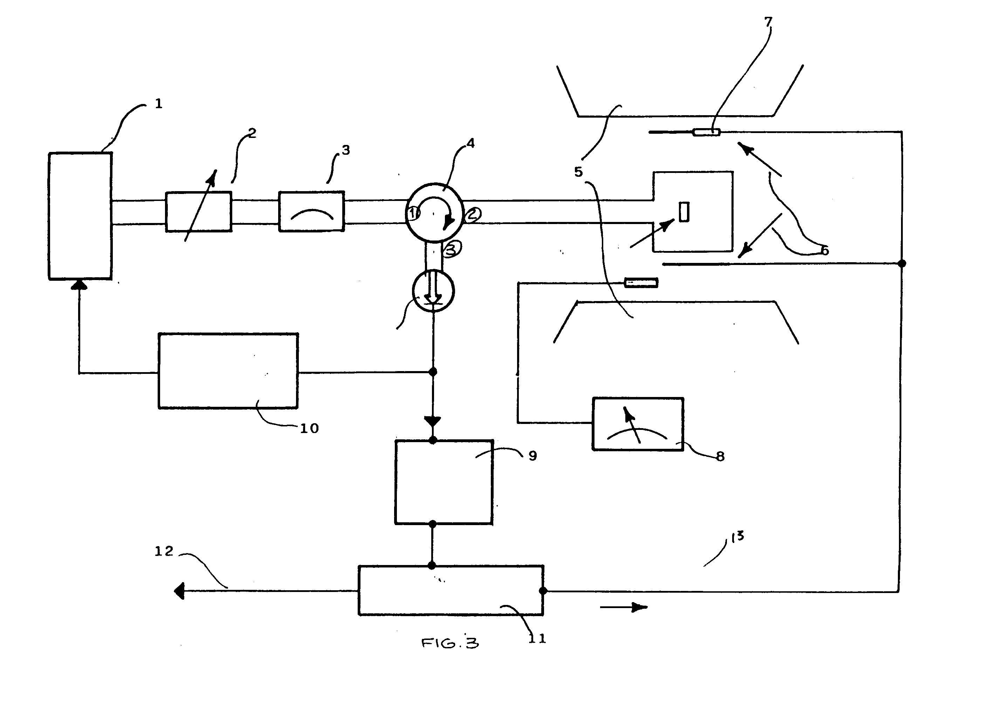

A typical experimental set-up for FMR (ferromagnetic resonance spect.) detection is outlined in fig.3.

As a consequence of the above, by varying bias field Hₒ, frequency and propagation vector K,it is possible to have a complete set of curves characterizing the dispersion of the various magnetostatic modes.

The most direct consequence of this fact is the possibility of delaying a microwave signal which has been injected, in an opportune manner, into the epitaxial film by means of microstrip transducers laid directly onto the magnetic film or, better still, onto an allumina substrate which can then be faced to the magnetic film.

Other possible applications, thanks to the low magnetic losses, are in the field of filters, resonators and oscillators.

In some circuit applications, such as filters, it may be necessary to attenuate or to suppress single modes or entire regions of the magnetostatic band.

The present invention has as an object the partial or total suppression of such modes, without increasing insertion losses of devices and assuring a complete rejection of spurious signals, which are undesirable within the bandwidth.

This can be achieved by modifying the magnetostatic spectrum by use of multilayer structures of epitaxial magnetic films which manifest diverse magnetic relaxation characteristics.

It is a well known fact (1) that the relaxation of the single magnetic ions contained within the crystal lattice, which is due to a number of physical processes, determines the total propagation losses within the sample.

The working principle of the present invention is that of overlaying, by means of further LPE growth, the magnetostatic low loss garnet layer (e.g. YIG, or La, Ga: YIG) with an absorption layer of garnet doped with high magnetic relaxation ions (such as Fe⁴⁺,Fe²⁺,Co²⁺, Rare Earths, etc.).

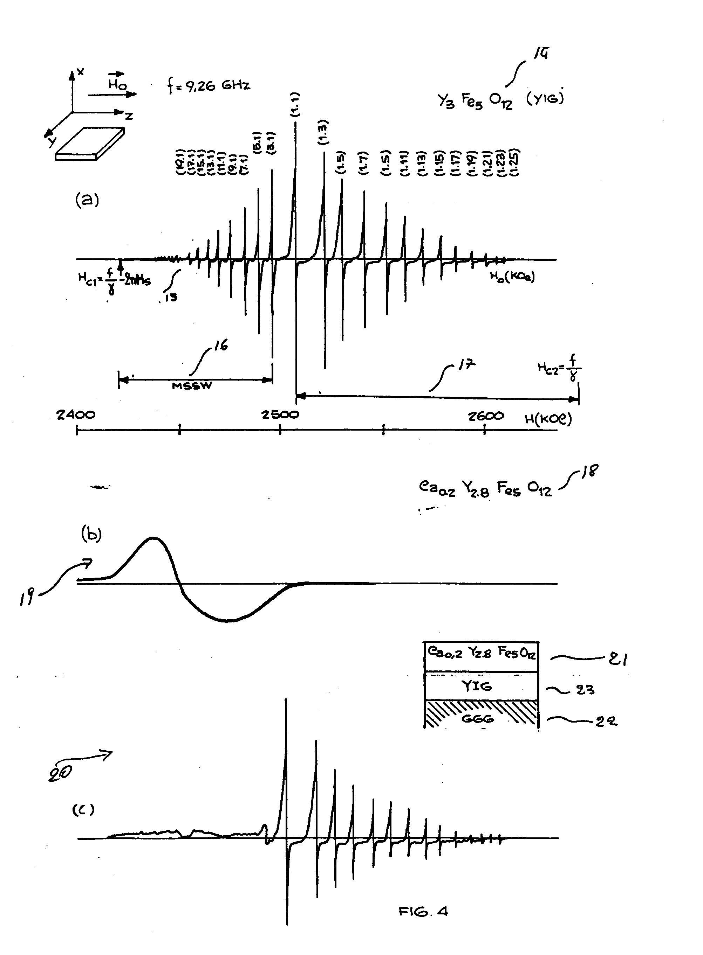

As a consequence, in an FMR experiment, modes which are related to the magnetostatic layer and which fit that area of the magnetic field which coincides with the lossy area related to the absorption layer, are in part attenuated or totally suppressed (cfr. fig.4). From a physical viewpoint, the magnetic losses of this second layer are, for Fe⁴⁺ or Fe²⁺ ions, in the main due to vortex current relaxation processes (2) arising from the presence of such ions which introduce an appreciable conductivity into the garnet (σ ≲ 10⁻³ Ω⁻¹ cm⁻¹ against σ ≈ 10⁻² Ω⁻¹ cm⁻¹ of pure garnets).

As this process is a function of the number of relaxing ions, of frequency, conductivity and chip surface area, as a consequence, the lossy region related to the absorption layer can be conveniently tailored by operating upon such parameters.

Relaxing ions enhancement within single or multiple absorption layers may be achieved by making recourse to different dopants during LPE growth (Liquid phase epitaxy). For total electrical charge compensation Fe⁴⁺ ions may, for instance, be generated through partial substitution within the garnet by means of bivalent diamagnetic ions such as Ca²⁺ (particularly effective), Mg²⁺,Be²⁺,Zn²⁺,Sr²⁺. In the case of Fe²⁺ ions, on the contrary, replacement by tetravalent diamagnetic ions may be exploited, such as Ge⁴⁺,Si⁴⁺,Th⁴⁺,Hg⁴⁺,Zr⁴⁺,Ti⁴⁺,Sn⁴⁺ or pentavalent such as V⁵⁺,Nb⁵⁺,Ta⁵⁺ or monovalent such as Li⁺.

Noticeable dissipating effects may also be obtained by direct embodiment of relaxing ions such as Co²⁺ and Rare Earths (Er³⁺,Ho³,Dy³⁺, etc; but not La³⁺ and Lu³⁺).

As an illustrative yet not limitative example the present invention will now be described with reference to the figures attached:
Fig. 1: Magnetostatic wave devices outline principles. GGG indicates the Gadolinium and Gallium Garnet substrate (Gd₃Ga₅O₁₂) over which the Yttrium and Iron Garnet (YIG) magnetostatic film is grown by Liquid Phase Epitaxy. The three orientations of the static bias magnetic field Hₒ are shown with respect to the wave vector K, which give way, in presence of YIG film exitation by r.f., to surface magnetostatic (MSSW), backward volume (MSBW) or forward volume (MSFW) modes respectively.
Fig. 2: Typical ferrimagnetic resonance spectrum FMR, obtained on a YIG chip (2.3x2.3 mm²) at 9.26 GHz with field Hₒ parallel to the film plane: A indicates surface modes, MSSW, and B indicates the volume modes, MSBW. The parallel wave numbers (n_{y}, n_{z}) are indicated next to each mode. The response is the first derivative of the absorption signal.
Fig. 3: Typical experimental set-up for ferrimagnetic resonance (FMR) measurement: as can be seen from the drawing, it includes a generator 1, an attenuator 2, a wavemeter 3, a circulator 4, a rectifying diode 13 and a waveguide cavity 7 which contains the sample under scrutiny. The above are completed by the electronic controls and amplifiers 10, the preamplifiers 9, lock-in 11 and plotter output 12. The magnetic field generated by electromagnet 5, modulated by coils 6, is measured by the gaussmeter 8.
Fig. 4: FMR spectrum in the same conditions as those applicable to Fig.2:
   - fig.4a :: FMR spectrum of bare YIG (Y₃Fe₅O₁₂) film (sensitivity scale x1):
   16 surface modes (MSSW)
   17 volume modes (MSBVW)
   - fig.4b :: FMR spectrum (sensitivity scale x 20) of bare absorption layer (e.g. Ca_{0.2}Y_{2.8}Fe₅O₁₂).
   - fig.4c :: FMR spectrum (sensitivity scale x 1) of composite structure consisting of single absorption layer (e.g. Ca_{0.2}Y_{2.8}Fe₅O₁₂) grown over YIG film:
   21 GGG non magnetic substrate
   22 YIG magnetic layer
   23 absorption layer
Fig. 5: examples of structures which may be used for magnetostatic mode suppression:
   a) two layer structure: 1 indicates the passive dielectric substrate, (generally constituted by GGG),which is needed for the LPE growth; 2 and 3 indicate respectively the magnetostatic layer (YIG or La, Ga: YIG) and the absorption layer (Ca Y )₃ Fe₅O₁₂ or (Cab Y)₃(Ga Fe)₅ O₁₂;
   b) multilayer substrate: 3 is the magnetostatic layer and 2 and 4 are the absorption layers;
   c) schematic of the implementation of a dissipative termination for the attenuation or the suppression of disturcance magnetostatic modes, related to reflections from periferic areas of the low loss garnet films, used for the implementation of microwave signal processing devices, such as delay lines, resoflators, oscillators and filters.

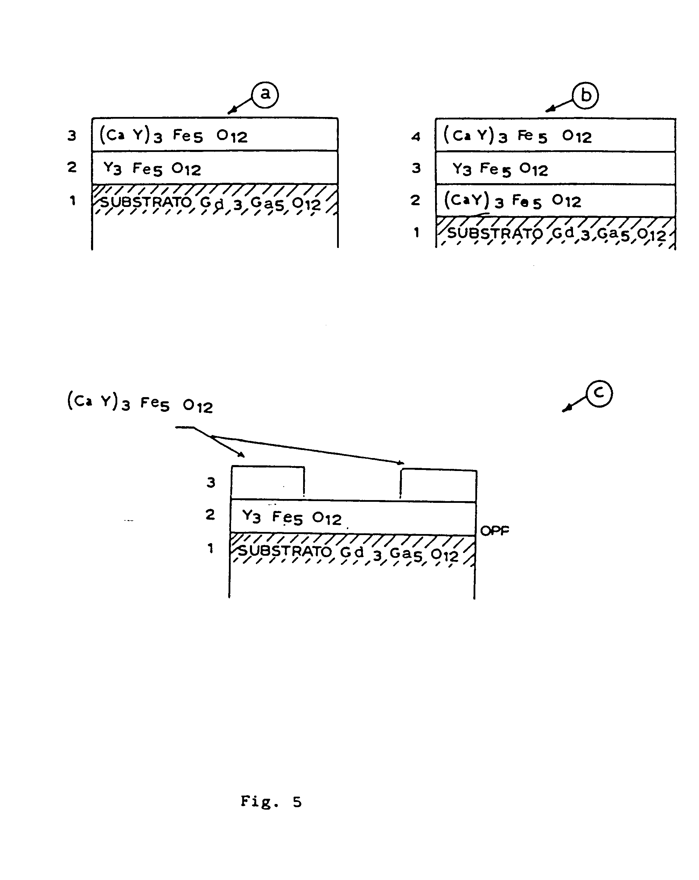

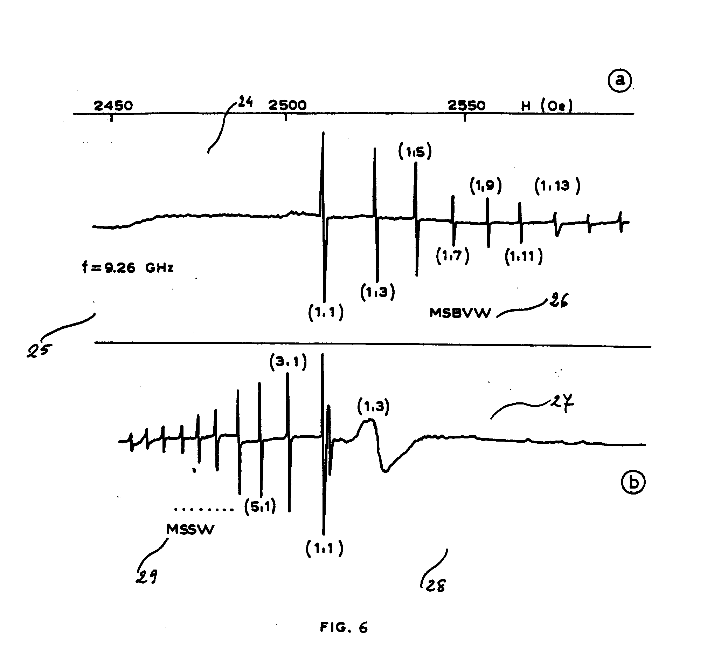

Fig. 6: typical modifications of an FMR spectrum (such as that of Fig.2) due to two different Calcium concentrations within layer 3 in fig.5a, with surface (6a) and volume (6b) mode suppression.
Fig. 6a: surface mode suppression obtained in parallel configuration at 9.26 GHz on a 0.28x0.20 cm² sample,25. Volume modes (right hand of the figure) are uneffected.
Fig. 6b: volume mode suppression obtained in the same conditions as above on a sample 0.22x0.21 cm²,28. Surface modes (left hand of the figure) are unaffected. Depending upon the quantity of Calcium within layer 3 of Fig.5a, different types of response may be expected, such as those depicted in Fig.6, i.e. controlled suppression of magnetostatic mode bands. A more complex structure such as, for example, the one in fig.5b without limitations of layers and compositions, implements a low pass filtering function of magnetostatic modes, with the possibility of selecting down to one single preselected mode.

Fig. 5c shows the implementation of a lossy termination for the attenuation or the suppression of disturbance magnetostatic modes which are due to periferic reflections within low loss garnet films used for the implementation of microwave signal processing devices, such as delay lines, resonators, oscillators, filters. The present invention affords a selectivity in the order of a few tens of MHz; furthermore its planar configuration gives way to an ease of integration within more complex structures, such as delay lines, resonators, oscillators, etc.

The multilayer epitaxial film configurations which are the subject of the present invention have nothing to do with other structures, already known, of overlaying different magnetization strata (still having low magnetic losses), or ground planes,which, independently from the fact that they may not be industrially implementable, by modifying only the boundary conditions of the magnetostatic films, modify the dispersion characteristics of the magnetostatic modes without making their attenuation or suppression possible.

### REFERENCES

(1) B.Lax and K.J.Button
   "Microwave Ferrites and Ferrimagnetics" McGrow-Hill N.Y. 1962
(2) C.Borghese and P.De Gasperis
   "On the nature of the microwave spectra and relaxation in conductive Fe⁴⁺ doped garnet films" IEEE Trans MAG-18(6) 1624 (1982)

## Claims

1. Method to controllably suppress magnetostatic waves in garnet films in microwave applications, characterized by the use of epitaxial layers of at least one low magnetic loss garnet film which serves as a magnetostatic layer and is made of YIG or (La, Ga) YIG; and at least one high magnetic loss garnet film which serves as an absorption layer and is doped with high magnetic relaxation ions, wherein the epitaxial layers have the same or similar magnetization.

2. Method according to claim 1, wherein the layers of high magnetic losses are implemented by the generation of magnetic relaxing ions Fe²⁺ and Fe⁴⁺.

3. Method according to claim 2, wherein the generation of relaxing ions Fe²⁺ and Fe⁴⁺ is due to the presence of monovalent (Li¹⁺) or bivalent (Ca²⁺, Mg²⁺, Be²⁺, Zn²⁺, Sr²⁺) or tetravalent (Ge⁴⁺, Si⁴⁺, Th⁴⁺, Hf⁴⁺, Zr⁴⁺, Ti⁴⁺, Sm⁴⁺) or pentavalent (V⁵⁺, Nb⁵⁺, Ta⁵⁺) diamagnetic ions, through total electrical charge compensation.

4. Method according to claim 1, wherein the layers of high magnetic losses take their relaxing properties from the direct introduction of relaxing ions Co²⁺ or Rare Earths (Er³⁺, Ho³⁺, Dy³⁺).

5. Method according to claims 2, 3 or 4, wherein the high magnetic loss layers are obtained by ion implantation.

6. Method according to anyone of the preceding claims, utilized to implement microwave circuit functions, such as resonators, stabilized oscillators, high selectivity tuneable filters.

7. Method according to anyone of claims 1 to 5, to control lossy terminations and to controllably suppress magnetostatic modes reflected by peripherical areas of low loss garnet films resulting in electrical improvement of devices for processing microwave signals in delay lines, resonators, oscillators and filters.

## Patentansprüche

1. Verfahren zum Unterdrücken von magnetostatischen Wellen in Granatfilmen für Mikrowellen-Anwendungsbereiche, gekennzeichnet durch die Verwendung von epitaxialen Schichten wenigstens eines Granatfilms mit geringem magnetischen Verlust, der als magnetostatische Schicht dient und aus YIC oder (La, Ga) - YIG besteht, und wenigstens eines Granatfilms mit hohem magnetischen Verlust, der als Absorptionsschicht dient und mit hochmagnetischen Relaxationsionen dotiert ist, wobei die epitaxialen Schichten gleiche oder ähnliche Magnetisierung haben.

2. Verfahren nach Anspruch 1, dadurch gekennzeichnet, daß die Schichten hoher magnetischer Verluste durch die Erzeugung magnetischer Relaxationsionen Fe²⁺ und Fe⁴⁺ gebildet werden.

3. Verfahren nach Anspruch 2, dadurch gekennzeichnet, daß die Erzeugung von Relaxationsionen Fe²⁺ und Fe⁴⁺ beruht auf der Gegenwart von einwertigen (Li¹⁺) oder zweiwertigen (Ca²⁺, Mg²⁺, Be²⁺ Zn²⁺, Sr²⁺) oder vierwertigen (Ge⁴⁺,Si⁴⁺, Th⁴⁺, Hf⁴⁺, Zr⁴⁺, Ti⁴⁺, Sm⁴⁺) oder fünfwertigen (V⁵⁺, Nb⁵⁺, Ta⁵⁺) diamagnetischen Ionen, wobei die Kompensation der elektrischen Ladung total ist.

4. Verfahren nach Anspruch 1, dadurch gekennzeichnet, daß die Schichten hoher magnetischer Verluste ihre Relaxationseigenschaften durch die direkte Einleitung von Relaxationsionen Co²⁺ oder seltener Erden (Er³⁺, Ho³⁺, Dy³⁺) erhalten.

5. Verfahren nach den Ansprüchen 2, 3 oder 4, dadurch gekennzeichnet, daß die Schichten hoher magnetischer Verluste durch Ionenimplantation erzeugt werden.

6. Verfahren nach einem der vorhergehenden Ansprüche zur Durchführung von Mikrowellen-Schaltungsfunktionen, z.B. bei Resonatoren, stabilisierten Oszillatoren oder abstimmbaren Filtern hoher Trennschärfe.

7. Verfahren nach einem der Ansprüche 1 bis 5 zur Steuerung von Leistungen mit hohen Verlusten und zur gesteuerten Unterdrückung magnetostatischer Erscheinungen, die durch periphere Bereiche von Granatfilmen geringer Verluste reflektiert werden, wodurch eine elektrische Verbesserung von Vorrichtungen zur Verarbeitung von Mikrowellensignalen in Verzögerungsleitungen, Resonatoren, Oszillatoren und Filtern erzielt wird.

## Revendications

1. Procédé de suppression réglable d'ondes magnétostatiques dans des pellicules en grenats destinées à des applications micro-ondes, caractérisé par l'utilisation de couches épitaxiales d'au moins une pellicule de grenat à faible perte magnétique qui sert de couche magnétostatique et qui consiste en un YIG ou (La, Ga) YIG; et au moins une pellicule de grenat à perte magnétique élevée qui sert de couche d'absorption et qui est dopée par des ions à haute relaxation magnétique, dans lequel la magnétisation, dans les couches épitaxiales, est la même ou est semblable.

2. Procédé selon la revendication 1, dans lequel les couches à pertes magnétiques élevées sont implantées par la génération d'ions relaxants magnétiques Fe²⁺ et Fe⁴⁺.

3. Procédé selon la revendication 2, dans lequel la génération d'ions relaxants Fe²⁺ et Fe⁴⁺ est due à la présence d'ions diamagnétiques monovalents (Li¹⁺) ou bivalents (Ca²⁺, Mg²⁺, Be²⁺, Zn²⁺, Sr²⁺) ou tétravalents (Ge⁴⁺, Si⁴⁺, Th⁴⁺, Hf⁴⁺, Zr⁴⁺, Ti⁴⁺, Sm⁴⁺) ou pentavalents (V⁵⁺, Nb⁵⁺, Ta⁵⁺), la compensation ------ de charge électrique étant totale.

4. Procédé selon la revendication 1, dans lequel les couches à pertes magnétiques élevées prennent leur propriété relaxante de l'introduction directe d'ions relaxants Co²⁺ ou de terres rares (Er³⁺, Ho³⁺, Dy³⁺).

5. Procédé selon l'une des revendications 2, 3 ou 4 dans lequel les couches à pertes magnétiques élevées sont obtenues par implantation ionique.

6. Procédé selon l'une quelconque des revendications précédentes, utilisé pour implanter des fonctions de circuits micro-ondes, comme des résonateurs, des oscillateurs stabilisés, des filtres accordables à haute sélectivité.

7. Procédé selon l'une quelconque des revendications 1 à 5, destiné à régler des terminaisons à fortes pertes et à supprimer de façon réglée des modes magnétostatiques réfléchis par des zones periphériques de pellicules de grenat à pertes faibles provoquant une amélioration électrique de dispositifs de traitement de signaux micro-ondes dans des lignes à retard, des résonateurs, des oscillateurs et des filtres.
